# EUROPÄISCHE PATENTANMELDUNG

(11) **EP 0 849 874 A1**
(43) Veröffentlichungstag der Anmeldung: **24.06.1998**
(21) Anmeldenummer: 97122317.7
(22) Anmeldetag: 17.12.1997
(51) Int. Cl.: H03F 1/30

(54) **Elektrische Schaltungsanordnung mit einem schaltbaren Rückkopplungszweig**

(30) Priorität: 19.12.1996 DE 19653191
(71) Anmelder: SGS-THOMSON MICROELECTRONICS GMBH, 85630 Grasbrunn (DE)
(72) Erfinder: Roither, Gerhard, 81827 München (DE); Hackl, Günther, 84503 Altötting (DE); Fischer, Uwe, 82008 Unterhaching (DE)
(74) Vertreter: Klunker . Schmitt-Nilson . Hirsch

(57) **Zusammenfassung**

Elekrische Schaltungsanordnung mit einem schaltbaren Rückkopplungszweig (Sr; S1, C, S2), der umschaltbar ist zwischen einem ersten Rückkopplungszustand, in welchem die Schaltungsanordnung einen hinsichtlich Schwingneigung stabilen Frequenzgang aufweist, und einem zweiten Rückkopplungszustand, in welchem die Schaltungsanordnung einen hinsichtlich Schwingneigung instabilen Frequenzgang aufweist, und mit einer schaltbaren Frequenzgangkompensationseinrichtung (Sfg, Cfg), die während des ersten Rückkopplungszustandes des Rückkopplungszweiges (Sr; S1, C, S2) unwirksam und während des zweiten Rückkopplungszustandes des Rückkopplungszweiges (Sr; S1, C, S2) wirksam schaltbar ist und im wirksamen Zustand eine derartige Kompensation des Frequenzgangs der im zweiten Rückkopplungszustand befindlichen Schaltungsanordnung bewirkt, daß die Schaltungsanordnung im zweiten Rückkopplungszustand hinsichtlich Schwingneigung stabil bleibt.

## Beschreibung

Die Erfindung betrifft eine elektrische Schaltungsanordnung mit einem schaltbaren Rückkopplungkreis, der umschaltbar ist zwischen einem ersten Rückkopplungszustand, in welchem die Schaltungsanordnung einen hinsichtlich Schwingneigung stabilen Frequenzgang aufweist, und einem zweiten Rückkopplungszustand, in welchem die Schaltungsanordnung einen hinsichtlich Schwingneigung instabilen Frequenzgang aufweist.

Es gibt viele elektrische Schaltungen mit einer Rückkopplung zwischen einem Signalausgang und einem Signaleingang einer signalverarbeitenden Schaltungseinrichtung. Wenn die Schaltungseinrichtung als Verstärker wirkt, kann es aufgrund der Rückkopplung zu unerwünschten Schwingungen der rückgekoppelten Schaltungseinrichtung kommen. Solche Schwingungen können auftreten, wenn die Gesamtverstärkung der rückgekoppelten Schaltungseinrichtung größer als 1 ist und der vom Signalausgang der Schaltungseinrichtung über den Rückkopplungszweig auf dessen Signaleingang rückgekoppelte Signalanteil in etwa phasengleich zu dem von einer Signalquelle dem Signaleingang der Schaltungseinrichtung zugeführten Eingangssignal ist (Mitkopplung). Um ein unerwünschtes Schwingen der rückgekoppelten Schaltungseinrichtung zu vermeiden, muß man die Gesamtverstärkung der rückgekoppelten Schaltungseinrichtung Kleiner als 1 halten und/oder muß man die Phasenlage des Ausgangssignals, das über den Rückkopplungszweig auf den Signaleingang der Schaltungseinrichtung rückgekoppelt wird, in ausreichendem Phasenabstand von dem Fall der phasengleichen Mitkopplung halten.

Zur Realisierung der zweitgenannten Maßnahme kann man herkömmlicherweise eine Frequenzgangkompensationsschaltung verwenden, mittels welcher in dem Frequenzbereich, in welchem Schwingneigung besteht, der Frequenzgang der rückgekoppelten Schaltungseinrichtung derart abgeändert wird, daß die Schwingneigung beseitigt ist. Hierzu kann man herkömmlicherweise einen Frequenzgangkompensationskondensator verwenden, der zwischen den Signalausgang der rückgekoppelten Schaltungseinrichtung und einen Masseanschluß geschaltet ist. Dieser Frequenzgangkompensationskondensator bewirkt, daß der Frequenzgang der rückgekoppelten Schaltungseinrichtung im oberen Frequenzbereich abgesenkt wird. Dies bedeutet, daß das Frequenzspektrum des mit der Schaltungseinrichtung verarbeiteten Signals im oberen Frequenzbereich beschnitten wird.

Eine derartige Frequenzgangabsenküng führt zu einer Verringerung des Verstärkungs-Bandbreite-Produktes der frequenzgangkompensierten Schaltungseinrichtung. Dient die Schaltungseinrichtung zur Verarbeitung oder Erzeugung von Rechteckimpulsen, führt die im oberen Frequenzbereich wirksame Frequenzgangkompensation zu einer Steilheitsverminderung der Impulsflanken eines solchen Rechtecksignals. Beides ist unerwünscht, letzeres insbesondere für schnelle digitale Schaltungen.

Beispiele für elektrische Schaltungsanordnungen mit einem Rückkopplungszweig, der in der eingangs angegebenen Weise zwischen zwei verschiedenen Rückkopplungszuständen umschaltbar ist, sind einerseits ein in SC-Technik (Switched Capacitor Technik) rückgekoppelter Verstärker oder ein Komparator, der über einen zwischen den Komparatoreingang und den Komparatorausgang geschalteten Schalter zwischen einem rückkopplungsfreien Zustand und einem stark rückgekoppelten Zustand umschaltbar ist.

Die SC-Technik wird im Bereich monolithisch integrierter Schaltungen verwendet. Dabei werden ohm'sche Widerstände, beispielsweise im Rückkopplungszweig eines Verstärkers, in der integrierten Schaltung nicht wirklich als ohm'sche Widerstände ausgebildet, da diese einerseits viel Chipfläche der integrierten Schaltung benötigen und andererseits nur schwer mit engen Toleranzen ihres Widerstandswertes herstellbar sind, sondern sie werden durch geschaltete Kondensatoren nachgebildet, die mit weniger Chipfläche auskommen und mit engeren Toleranzen herstellbar sind. Bei der bereits bekannten SC-Technik wird ein den ohm'-schen Widerstand ersetzender Kondensator mittels zweier beidseits des Kondensators angeordneter Schalter periodisch umgeladen. Im Fall eines Verstärkers mit SC-Rückkopplung befindet sich zwischen dem SC-Kondensator und dem Verstärkereingang ein erster SC-Schalter und zwischen dem Kondensator und dem Verstärkerausgang ein zweiter SC-Schalter. In einem ersten Schaltzustand der beiden Schalter ist der Verstärkerausgang über den Kondensator auf den Verstärkereingang rückgekoppelt. In einem zweiten Schaltzustand der beiden Schalter sind die beiden Seiten des Kondensators je mit einem Masseanschluß verbunden. Bei dieser Verstärkerschaltung bewirken somit die beiden Schalter ein Umschalten des Rückkopplungszweiges derart, daß im ersten Schaltzustand eine Rückkopplung über den Kondensator besteht, während im zweiten Schaltzustand der Rückkopplungszweig offen ist, somit keine Rückkopplung stattfindet.

Der bereits erwähnte Komparator mit einem Schalter im Rückkopplungszweig findet Verwendung für eine Analogsignal-Rechtecksignal-Umformschaltung mit Offsetkompensation, wie sie in der gleichzeitig mit vorliegender Anmeldung eingereichten Patentanmeldung "Analogsignal-Rechtecksignal-Umformvortichtung mit Offset-Kompensation" (Anwalts-Aktenzeichen K 43 953/6) derselben Anmelderin näher beschrieben ist. Bei dieser Umformschaltung ist zwischen den Komparatorausgang und den Komparatoreingang eines offset-behafteten Komparators ein steuerbarer Schalter geschaltet, der bei normalem Komparatorbetrieb geöffnet ist, so daß zwischen Komparatorausgang und Komparatoreingang keine Rückkopplung stattfindet, und der zu Zwecken der Offsetmessung und der Offsetspeicherung in einem Offsetspeicherkondensator vorübergehend geschlossen wird und dann eine starke Rückkopplung zwischen Komparatorausgang und Komparatoreingang bewirkt. Während im Fall des Verstärkers mit SC-Rückkopplung über den SC-Kondensator und im Fall des Komparators mit Offsetkompensation Rückkopplung über den leitend geschalteten Rückkopplungsschalter besteht, kann Instabilität hinsichtlich Schwingneigung bestehen. Dies kann man in der bereits erwähnten Weise mittels einer Frequenzgangkompensationsschaltung, insbesondere in Form des bereits erwähnten Frequenzgangkompensators beseitigen, allerdings unter der ebenfalls bereits genannten Einbuße an Verstärkungs-Bandbreite-Produkt bzw. Impulsflankensteilheit.

Der Erfindung liegt die Aufgabe zugrunde, bei Schaltungsanordnungen mit schaltbarer Rückkopplung und Schwingneigung Maßnahmen zu treffen, mittels welchen die Schwingneigung beseitigt wird, ohne daß es zu unerwünschter oder beeinträchtigender Verringerung des Verstärkungs-Bandbreite-Produktes bzw. zur Verringerung der Flankensteilheit kommt.

Dies wird erreicht mit einer erfindungsgemäßen Schaltungsanordnung, wie sie im Anspruch 1 angegeben ist. Ausführungsformen der Erfindung sind den abhängigen Ansprüchen entnehmbar.

Demgemäß schafft die vorliegende Erfindung eine elektrische Schaltungsanordnung mit einem schaltbaren Rückkopplungszweig, der umschaltbar ist zwischen einem ersten Rückkopplungszustand, in welchem die Schaltungsanordnung einen hinsichtlich Schwingneigung stabilen Frequenzgang aufweist, und einem zweiten Rückkopplungszustand, in welchem die Schaltungsanordnung einen hinsichtlich Schwingneigung instabilen Frequenzgang aufweist, und mit einer schaltbaren Frequenzgangkompensationseinrichtung, die während des ersten Rückkopplungszustandes des Rückkopplungszweiges unwirksam und während des zweiten Rückkopplungszustandes des Rückkopplungszweiges wirksam schaltbar ist und im wirksamen Zustand eine derartige Kompensation des Frequenzgangs der im zweiten Rückkopplungszustand befindlichen Schaltungsanordnung bewirkt, daß die Schaltungsanordnung im zweiten Rückkopplungszustand hinsichtlich Schwingneigung stabil bleibt.

Die beiden unterschiedlichen Rückkopplungszustände können Zustände unterschiedlich starker Rückkopplung sein oder ein Zustand mit Rückkopplung und ein Zustand mit offenem Rückkopplungszweig, also ohne Rückkopplung.

In den Fällen mit umschaltbarer Rückkopplung, beispielsweise den beiden bereits erwähnten Beispielen eines Verstärkers mit SC-Rückkopplung und einer Komparatorschaltung zur Analogsignal-Rechtecksignal-Umformung mit Offsetkompensation, kommt es im allgemeinen nur während des rückkopplungsfreien Zustandes auf den Frequenzgang der Schaltungsanordnung an. Betrachtet man beispielsweise die Komparatorschaltung für die Analogsignal-Rechtecksignal-Umformung, ist die Fähigkeit, steile Impulsflanken zu erzeugen, nur während derjenigen Zeitabschnitte interessant, während welcher wirklich Impulsflanken auftreten, nicht jedoch dazwischen. Bei der erfindungsgemäßen Lösung, bei welcher die Frequenzgangkompensation nur während des Schaltungszustandes mit Rückkopplung durchgeführt wird, werden die Impulsflanken des Rechtecksignals somit in keiner Weise von der Frequenzgangkompensation beeinträchtigt, da die Frequenzgangkompensation während der Zeiten des Auftretens von Impulsflanken unwirksam geschaltet ist.

Bei einer bevorzugten Ausführungsform der Erfindung weist die Frequenzgangkompensationseinrichtung eine Reihenschaltung mit einem steuerbaren Frequenzgangkompensationsschalter und einem Frequenzgangkompensationskondensator auf, die zwischen einen Ausgang der Schaltungsanordnung und einen Masseanschluß geschaltet ist. Während desjenigen Rückkopplungszustandes, während welchem Schwingneigung besteht, wir der Frequenzgangkompensationsschalter leitend geschaltet, so daß es zu einer Absenkung des Frequenzgangs im oberen Frequenbereich kommt, was die Schwingneigung beseitigt. Im Rückkopplungszustand ohne Schwingneigung wird der Frequenzgangkompensationsschalter geöffnet, der Frequenzgangkompensationskondensator somit unwirksam geschaltet und der Frequenzgang der Schaltungsanordnung nicht kompensiert und damit auch nicht beeinträchtigt.

Bei einer Ausführungsform der Erfindung weist die Schaltungsanordnung einen Verstärker auf, der über eine SC-Schaltung rückgekoppelt ist, die eine zwischen einen Signalausgang und einen Signaleingang des Verstärkers geschaltete Reihenschaltung mit einem SC-Kondensator und einem zwischen Signaleingang und SC-Kondensator befindlichen ersten SC-Schalter und einen zwischen SC-Kondensator und Signalausgang geschalteten zweiten SC-Schalter aufweist. Dabei schalten die beiden SC-Schalter den SC-Kondensator in einem ersten Schaltungszustand in Reihe zwischen Signaleingang und Signalausgang des Verstärkers und verbinden die beiden SC-Schalter den SC-Kondensator in einem zweiten Schaltzustand beidseits mit Masse. Dabei ist der Frequenzgangkompensationsschalter während des ersten Schaltzustandes der beiden SC-Schalter leitend und während des zweiten Schaltzustandes der SC-Schalter nicht-leitend steuerbar.

Bei einer Ausführungsform der Erfindung mit einem Komparator, dessen Signaleingang und Signalausgang über einen Rückkopplungsschalter miteinander verbunden sind, der in dem ersten Rückkopplungszustand nicht-leitend und im zweiten Rückkopplungszustand leitend gesteuert ist, wird der Frequenzgangkompensationsschalter sychron mit dem Rückkopplungsschalter leitend und nicht-leitend gesteuert. Dadurch findet eine Frequenzgangkompensation immer nur dann statt, wenn der Rückkopplungsschalter leitend geschaltet ist und ohne die Frequenzgangkompensation Schwingneigung besteht.

Bei einer weiteren Ausführungsform der Erfindung wird die erfindungsgemäße Schaltungsanordnung mit Komparator in einer Analogsignal-Rechtecksignal-Umformschaltung eingesetzt, wobei der Komparator dazu ausgelegt ist, eine schwellenabhängige Umformung von einem dessen Signaleingang zugeführten Analogsignal in ein von dessen Signalausgang abnehmbares Rechtecksignal durchzuführen ist, und zwar mit Offset-Kompensation des offset-behafteten Komparators. Dabei sind der den Komparator rückkoppelnde Rückkopplungsschalter und der Frequenzgangkompensationsschalter gleichlaufend zwischen den Zeitpunkten benachbarter Impulsflanken des Rechtecksignals vorübergehend leitend und im Bereich der Impulsflanken des Rechtecksignals nicht-leitend steuerbar. Für die Offsetkompensation ist ein Offset-Speicherkondensator vorgesehen, der in Reihenschaltung zwischen eine Analogsignalquelle und den Signaleingang des Komparators geschaltet ist. Der Offset-Speicherkondensator ist durch Leitendschalten des Rückkopplungsschalters auf eine der Offsetspannung des Komparators entsprechende Ladespannung aufladbar, die nach dem anschließenden Umschalten des Rückkopplungsschalters in den nicht-leitenden Zustand zur Offsetkompensation dem von der Analogsignalquelle gelieferten Analogsignal überlagerbar ist.

Die Erfindung wird nun anhand von Ausführungsformen näher erläutert. In den beiliegenden Zeichnungen zeigen:
**Fig. 1** eine erste Ausführungsform einer erfindungsgemäßen Schaltungsanordnung für eine Analogsignal-Rechtecksignal-Umformung mit schaltbarer Frequenzgangkompensation;
**Fig. 2** einen herkömmlichen Operationsverstärker mit Rückkopplung über einen ohm'schen Widerstand; und
**Fig. 3** einen Operationsverstärker mit SC-Rückkopplung und schaltbarer Frequenzgangkompensation.

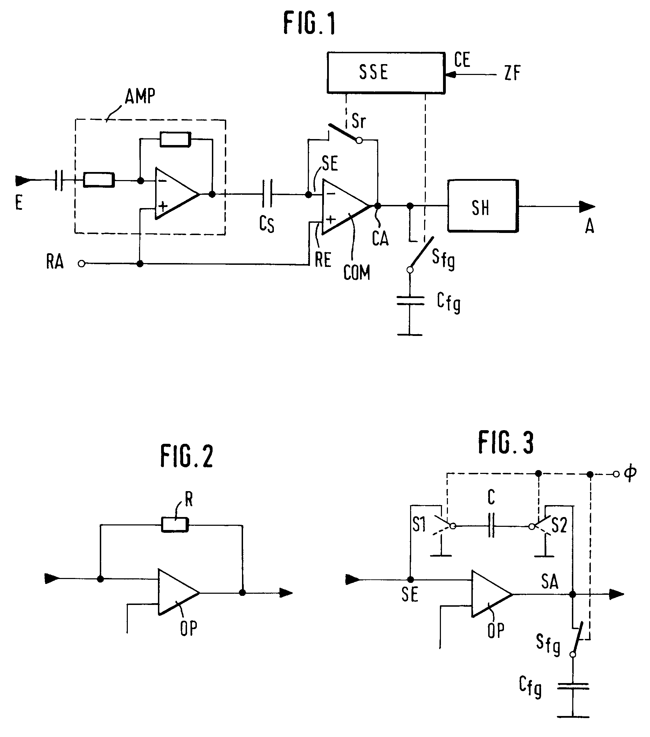

Bei der in Fig. 1 gezeigten Schaltungsanordnung handelt es sich um eine Analogsignal-Rechtecksignal-Umformschaltung mit Offset-Kompensation und mit schaltbarer Frequenzgangkompensation. Mit Ausnahme des die schaltbare Frequenzgangkompensation bewirkenden Schaltungsteils stimmt die in Fig. 1 gezeigte Schaltungsanordnung mit der Analogsignal-Rechtecksignal-Umformvorrichtung überein, die in der bereits genannten gleichzeitig eingereichten deutschen Patentanmeldung (Anwalts-Aktenzeichen K 43 953/6), deren Inhalt hiermit ausdrücklich durch Bezugnahme in den Offenbarungsgehalt der vorliegenden Patentanmeldung mit aufgenommen wird, hinsichtlich Schaltungsaufbau, Zweck und Funktion ausführlich beschrieben ist.

Dabei liefert eine Analogsignalquelle in Form eines Analogverstärkers AMP mit einem Signaleingang E über einen Offset-Speicherkondensator CS ein Analogsignal an einen invertierenden Signaleingang SE eines Komparators COM, dessen nicht-invertierendem Referenzeingang RE eine Referenzspannung zugeführt wird, mittels welcher für den Komparator ein Schwellenwert definiert wird. Dieser Schwellenwert dient als Diskriminationsschwelle für die Analogsignal-Rechtecksignal-Umformung. Da Komparatoren von Haus aus mit einer Offsetspannung behaftet sind, die sich wie eine Verfälschung der Diskriminationsschwelle auswirkt, kommt es infolge des Offsetfehlers des Komparators bei dem an einem Komparatorausgang CA abnehmbaren Rechtecksignal zu einer Verfälschung hinsichtlich der Zeitpunkte, an welchen die Flanken des Rechtecksignals auftreten.

Dieses Problem wird mittels einer Offsetkompensation beseitigt, für welche der Offset-Speicherkondensator Cs und ein zwischen SE und CA geschalteter Rückkopplungsschalter Sr vorgesehen sind. Mittels einer Schaltersteuereinrichtung SSE ist der Rückkopplungsschalter Sr derart steuerbar, daß er sich im zeitlichen Bereich der Flanken des Rechtecksignals im nicht-leitenden Zustand und in Zeitabschnitten oder Zeitfenstern zwischen benachbarten Flanken des Rechtecksignals vorübergehend im leitenden Zustand befindet. Zu diesem Zweck wird mittels einer (nicht dargestellten) Detektionsschaltung zu Zeitpunkten, zu welchen das Analogsignal oder das Rechtecksignal eine bestimmte Detektionsschwelle durchläuft, beispielsweise zum Zeitpunkt eines Nulldurchgangs, ein Detektionssignal erzeugt, das Detektionssignal um eine vorbestimmte Zeitdauer verzögert und am Ende der Verzögerungszeit das Zeitfenster geöffnet und während der Dauer des Zeitfensters der Schaltersteuereinrichtung SSE über einen Steuereingang CE ein Zeitfenstersignal ZF zugeführt.

Während der Dauer des Zeitfensters ist der Rückkopplungsschalter Sr leitend geschaltet und auf diese Weise ein erster Rückkopplungszustand erzeugt, in dem eine vollständige Rückkopplung zwischen CA und SE des Komparators COM bewirkt wird. Außerhalb des Zeitfensters ist der Rückkopplungsschalter Sr nicht-leitend gesteuert, somit ein zweiter Rückkopplungszustand bewirkt, in welchem keinerlei Rückkopplung besteht.

Bei einem idealen Komparator ohne Offset treten an den drei Anschlüssen SE, RE und CA identische Spannungswerte auf. Aufgrund der Offsetspannung des Komparators COM tritt während der Rückkopplung über den leitend gesteuerten Rückkopplungsschalter Sr in Wirklichkeit am Signaleingang SE ein um die Offsetspannung höherer Spannungswert auf als an den Anschlüssen RE und CA des Komparators COM. Der Offset-Speicherkondensator Cs wird daher während des Leitend-Steuerns des Rückkopplungsschalters Sr auf die Offsetspannung aufgeladen.

Wird der Komparator COM durch das Öffnen des Rückkopplungsschalters Sr am Ende des Zeitfensters wieder in seinen normalen Komparatorbetrieb rückgeschaltet, wird dem vom Verstärker AMP gelieferten Analogsignal die im Offset-Speicherkondensator Cs gespeicherte Offsetspannung überlagert. Damit kann am Komparatorausgang CA der beim Durchlaufen der Komparatorschwelle stattfindende Potentialsprung trotz Offsetverhalten des Komparators COM schon bei einem Signalwert des Analogsignals auftreten, der ohne Offsetkompensation einen solchen Potentialsprung am Komparatorausgang CA noch nicht bewirken könnte.

Aufgrund der hohen Verstärkung, die ein Komparator üblicherweise aufweist, und der totalen Rückkopplung durch das Leitendschalten des Rückkopplungsschalters Sr während des Zeitfensters besteht während der Zeitfensterdauer eine unerwünschte Schwingneigung des rückgekoppelten Komparators COM. Diese wird erfindungsgemäß unterbunden mit Hilfe einer Frequenzgangkompensationseinrichtung, die eine zwischen den Komparatorausgang CA und Masse geschaltete Reihenschaltung mit einem Frequenzgangkompensationsschalter Sfg und einem Frequenzgangkompensationskondensator Cfg aufweist. Der Frequenzgangkompensationsschalter Sfg ist über die Schaltersteuereinrichtung SE gleichlaufend mit dem Rückkopplungsschalter Sr leitend und nicht-leitend steuerbar, derart, daß der Frequenzgangkompensationskondensator Cfg durch Leitendschalten des Frequenzgangkompensationsschalters Sfg während derjenigen Zeiten frequenzgangkompensierend geschaltet ist, während welcher der Rückkopplungsschalter Sr leitend geschaltet ist. Ist dagegen Sr nicht-leitend geschaltet, ist auch Sfg nicht-leitend, so daß der Frequenzgangkompensationskondensator Cfg vom Komparatorausgang CA abgetrennt ist und keine Frequenzgangkompensation ausübt, also während Zeiten, zu welchen der Rückkopplungszweig des Komparators COM offen ist und keine Schwingneigung besteht.

Da die Frequenzgangkompensation in Form einer Beschneidung des Frequenzgangs im oberen Frequenzbereich nur während der Dauer des Zeitfensters durchgeführt wird, also nur während Zeitabschnitten außerhalb der Flanken des Rechtecksignals, während des Auftretens dieser Flanken die Frequenzgangkompensation jedoch unterbleibt, ist die Schwingneigung dieser Schaltungsanordnung beseitigt, ohne die Flankensteilheit der Rechteckimpulse zu beeinträchtigen.

Würde man (in herkömmlicher Weise) eine Frequenzgangkompensation permanent durchführen, wäre zwar die Schwingneigung erfolgreich beseitigt, würde jedoch die Steilheit der Flanken des Rechtecksignals vermindert.

Anhand der Figuren 2 und 3 wird nun eine zweite Ausführungsform der Erfindung erläutert. Fig. 2 zeigt in wohlbekannter Weise einen Teil eines Verstärkers, der einen Operationsverstärker OP und einen ohm'schen Rückkopplungswiderstand R umfaßt. Ohm'sche Widerstände benötigen in monolithisch integrierten Halbleiterschaltungen viel Chipfläche und lassen sich bei normalem Aufwand nur mit relativ groben Toleranzen herstellen. Dieses Problem hat man im Bereich von integrierten Halbleiterschaltungen dadurch überwunden, daß man ohm'sche Widerstände durch sogenannte geschaltete Kondensatoren ersetzt, die aus dem englischsprachigen Raum übernommen SC (Switched Capacitors) genannt werden.

Fig. 3 zeigt ein Beispiel eines Verstärkers, dessen Operationsverstärker in SC-Technik rückgekoppelt ist. Zu diesem Zweck befindet sich im Rückkopplungszweig des Operationsverstärkers OP eine Reihenschaltung aus einem SC-Kondensator C, einem C mit einem Signaleingang SE verbindenden ersten Schalter S1 und einem C mit einem Signalausgang SA des Operationsverstärkers OP verbindenden zweiten Schalter S2.

Beide Schalter S1 und S2 sind synchron über ein Taktsignal Φ in einen ersten Schaltzustand, in welchem sie über C eine Rückkopplung zwischen SA und SE herstellen, und einem zweiten Schaltzustand, in welchem sie beide Seiten von C je mit Masse verbinden, steuerbar. Die mittels Φ periodisch zwischen den beiden Schaltzuständen umgeschaltete SC-Schaltung mit C, S1 und S2 wirkt wie der ohm'sche Widerstand R in Fig. 2, läßt sich jedoch mit geringerem Platzaufwand und mit engeren Toleranzen als ein ohm'scher Widerstand monolithisch integrieren.

Da Operationsverstärker im allgemeinen eine hohe Verstärkung haben, kann es während der Rückkopplungszustände, in welchen eine Rückkopplung über C geschaltet ist, zur Schwingneigung des rückgekoppelten Operationsverstärkers OP kommen. Diese Schwingneigung wird mittels einer schaltbaren Frequenzgangkompensation beseitigt, welche den gleichen Schaltungsaufbau wie in Fig. 1 aufweist, nämlich eine Reihenschaltung aus einem Frequenzgangkompensationsschalter Sfg und einem Frequenzgangkompensationskondensator Cfg, die zwischen den Signalausgang SA des Operationsverstärkers OP und Masse geschaltet ist.

Da über den SC-Kondensator C eine Rückkopplung nur wahrend des (in Fig. 3 gezeigten) ersten Schaltzustandes von S1 und S2 besteht, wird der Frequenzgangkompensationsschalter Sfg nur während dieses ersten Schaltzustandes von S1 und S2 leitend gesteuert, jedoch nicht während derjenigen Zeitabschnitte, während welcher sich S1 und S2 im zweiten Schaltzustand befinden, die Rückkopplung über den SC-Kondensator C somit unterbrochen ist.

Eine Frequenzgangbeschneidung im oberen Frequenzbereich und eine damit einhergehende Verringerung des Verstärkungs-Bandbreite-Produktes durch die Frequenzgangkompensationsschaltung Sfg und Cfg findet somit nicht statt, während der Rückkopplungszweig von OP offen ist, sondern nur während der Zeiten der Rückkopplung über den SC-Kondensator C.

## Patentansprüche

1. Elekrische Schaltungsanordnung mit einem schaltbaren Rückkopplungszweig (Sr; S1, C, S2), der umschaltbar ist zwischen einem ersten Rückkopplungszustand, in welchem die Schaltungsanordnung einen hinsichtlich Schwingneigung stabilen Frequenzgang aufweist, und einem zweiten Rückkopplungszustand, in welchem die Schaltungsanordnung einen hinsichtlich Schwingneigung instabilen Frequenzgang aufweist,
und mit einer schaltbaren Frequenzgangkompensationseinrichtung (Sfg, Cfg), die während des ersten Rückkopplungszustandes des Rückkopplungszweiges (Sr; S1, C, S2) unwirksam und während des zweiten Rückkopplungszustandes des Rückkopplungszweiges (Sr; S1, C, S2) wirksam schaltbar ist und im wirksamen Zustand eine derartige Kompensation des Frequenzgangs der im zweiten Rückkopplungszustand befindlichen Schaltungsanordnung bewirkt, daß die Schaltungsanordnung im zweiten Rückkopplungszustand hinsichtlich Schwingneigung stabil bleibt.

2. Elektrische Schaltungsanordnung nach Anspruch 1, bei welcher die Frequenzgangkompensationseinrichtung (Sfg, Cfg) außerhalb des Rückkopplungsnetzwerkes angeordnet ist.

3. Schaltungsanordnung nach Anspruch 1 oder 2, bei welcher die Frequenzgangkompensationseinrichtung eine Reihenschaltung mit einem steuerbaren Frequenzgangkompensationsschalter (Sfg) und einem Frequenzgangkompensationskondensator (Cfg) aufweist, die zwischen einen Ausgang (CA; SA) der Schaltungsanordnung und einen Masseanschluß geschaltet ist.

4. Schaltungsanordnung nach Anspruch 3,
mit einem Verstärker (OP), der über eine SC-Schaltung (S1, C, S2) rückgekoppelt ist, die eine zwischen einen Signalausgang (SA) und einen Signaleingang (SE) des Verstärkers (OP) geschaltete Reihenschaltung mit einem SC-Kondensator (C), einen zwischen Signaleingang (SE) und SC-Kondensator (C) befindlichen ersten SC-Schalter (S1) und einen zwischen SC-Kondensator (C) und Signalausgang (SA) geschalteten zweiten SC-Schalter (S2) aufweist, wobei die beiden SC-Schalter (S1, S2) den SC-Kondensator (C) in einem ersten Schaltzustand in Reihe zwischen den Signaleingang (SE) und den Signalausgang (SA) des Verstärkers (OP) schalten und die beiden SC-Schalter (S1, S2) den SC-Kondensator (C) in einem zweiten Schaltzustand beidseits je mit Masse verbinden, und wobei der Frequenzgangkondensator (Cfg) während des ersten Schaltzustandes der beiden SC-Schalter (S1, S2) leitend und während des zweiten Schaltzustandes der SC-Schalter (S1, S2) nichtleitend steuerbar ist.

5. Schaltungsanordnung nach Anspruch 3, mit einem Komparator (COM), der einen Signaleingang (SE) und einen Komparatorausgang (CA) aufweist, die über einen steuerbaren Rückkopplungsschalter (Sr) miteinander verbunden sind, derart, daß sich der Komparator (COM) bei nicht-leitend gesteuertem Rückkopplungsschalter (Sr) in einem rückkopplungsfreien ersten Rückkopplungszustand und bei leitend gesteuertem Rückkopplungsschalter (Sr) in einem zweiten Rückkopplungszustand mit starker Rückkopplung befindet, wobei der Frequenzgangkompensationsschalter (Sfg) gleichzeitig mit dem Rückkopplungsschalter (Sr) leitend und nicht-leitend steuerbar ist.

6. Analogsignal-Rechtecksignal-Umformschaltung mit einer Schaltungsanordnung nach Anspruch 5, dessen Komparator (COM) offsetbehaftet ist und mittels welchem eine schwellenabhängige Umformung von einem dessen Signaleingang (SE) zugeführten Analogsignal in ein von dessen Komparatorausgang (CA) abnehmbares Rechtecksignal durchführbar ist, und deren Rückkopplungsschalter (Sr) und Frequenzgangkompensationsschalter (Sfg) gleichlaufend zwischen Zeitpunkten benachbarter Impulsflanken des Rechtecksignals vorübergehend leitend und im Bereich der Impulsflanken des Rechtecksignals nicht-leitend steuerbar sind, und mit einem Offset-Speicherkondensator (Cs), der in Reihenschaltung zwischen eine Analogsignalquelle (AMP) und den Signaleingang (SE) des Komparators (COM) geschaltet ist und der durch Leitend-Schalten des Rückkopplungsschalters (Sr) auf eine der Offsetspannung des Komparators (COM) entsprechende Ladespannung aufladbar ist, die nach dem anschließenden Umschalten des Rückkopplungsschalters (Sr) in den nicht-leitenden Zustand zur Offsetkompensation dem von der Analogsignalquelle (AMP) gelieferten Analogsignal überlagerbar ist.
